(19) Europäisches Patentamt
European Patent Office
Office européen des brevets

(11) **EP 4 760 282 A1**

(12) **EUROPEAN PATENT APPLICATION**

(43) Date of publication:
**17.06.2026 Bulletin 2026/25**

(21) Application number: **25221310.3**

(22) Date of filing: **05.12.2025**

(51) International Patent Classification (IPC):
**G01R 31/08** $^{(2020.01)}$

(52) Cooperative Patent Classification (CPC):
**G01R 31/088; G01R 31/08**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **12.12.2024 US 202463733232 P
04.12.2025 US 202519408846**

(71) Applicant: **Schweitzer Engineering Laboratories,
Inc.
Pullman, WA 99163 (US)**

(72) Inventors:
• **Kasztenny, Bogdan
Markham (CA)**
• **Smelich, Gregory
Butte (US)**
• **Guzman-Casillas, Armando
Pullman (US)**

(74) Representative: **Smith, Jeremy Robert
Kilburn & Strode LLP
Lacon London
84 Theobalds Road
London WC1X 8NL (GB)**

(54) **ELECTRIC POWER SYSTEM FAULT LOCATION USING INCREMENTAL QUANTITIES**

(57)    Fault location determination using local and remote incremental voltages and replica currents is disclosed herein. Using the observation that the change in voltage at the fault location estimated from a local terminal is the same as the change in voltage at the fault location estimated from a remote terminal, the embodiments herein determine fault location by minimizing a difference between a change-in-voltage at the fault location estimated using the local incremental voltages and replica currents and a change-in-voltage at the fault location estimated using the remote incremental voltages and replica currents.

**Figure 1**

EP 4 760 282 A1

**Description**

Technical Field

This disclosure relates to locating faults in an electric power delivery system using incremental quantities. In particular a fault location is determined by matching the change in voltage at the fault location calculated from the local and separately from the remote incremental voltages and incremental replica currents.

Brief Description of the Drawings

Non-limiting and non-exhaustive embodiments of the disclosure are described, including various embodiments of the disclosure with reference to the figures, in which:

> **Figure 1** illustrates a one-line diagram of an electrical power delivery system comprising Intelligent Electronic Devices (IEDs) implementing fault location in accordance with several embodiments herein.
> **Figure 2** illustrates a plot of a change in voltage at the fault point estimates in accordance with several embodiments herein.
> **Figure 3** illustrates a power line and plots of change-in-voltages at the local and remote terminals for assumed fault locations in accordance with several embodiments herein.
> **Figure 4** illustrates a plot of a change in voltage at the fault location signal over a time window in accordance with several embodiments herein.
> **Figure 5** illustrates a multi-terminal power line with a fault in accordance with several embodiments herein.
> **Figure 6** illustrates a hybrid line and a plot of positive-sequence impedance in accordance with several embodiments herein.
> **Figure 7** illustrates a hybrid line and plots of the local and remote change-in-voltage signals to determine a fault location in accordance with several embodiments herein.
> **Figure 8** illustrates plots of a minimization function and related fault location estimates as a function of time shift between local and remote signals in accordance with several embodiments herein.

Detailed Description

Electric power delivery systems are typically monitored and protected by IEDs that obtain electrical measurements such as voltage and current from the power system and use those measurements to determine a condition of the power system. IEDs are used to monitor and protect (such as signaling a circuit breaker to trip) the power system including calculating a location of power line faults.

Accurate and dependable fault locating improves power system operations by shortening the line inspection time, streamlining the repair work, and leading to faster restoration of critical lines.

Traveling-wave-based fault locators (TWFLs) are accurate and dependable. The pace of TWFL installations has increased steadily in the last two decades, and since 2012, TWFLs have been available in line protective relays. However, in rare cases, such as an unfavorable type of line termination or faults with precursors, a TWFL can fail to locate a fault, making an accurate backup fault-locating method necessary.

Ultra-high-speed (UHS) line protective relays that are based on fault transients (incremental quantities and traveling waves) emerged in the last decade. These relays routinely trip in less than 3 ms. When applied with two-cycle breakers, UHS relays often clear line faults in 1.5 power cycles. Such a short fault-clearing time challenges fault locators that are based on phasors. A full-cycle phasor estimator takes about 1.25 cycles to obtain a stable phasor. Just when the phasor becomes stable at 1.25 cycles, the breaker starts to open at 1.5 cycles. As a result, a phasor-based fault locator may have less than 0.25 cycle of stable fault phasor data to work with. Transients present in the voltages and currents during faults extend the phasor estimator settling time. As a result, a phasor-based fault locator may have no accurate data to work with for faults cleared in 1.5 cycles.

Shortening the phasor data window to cope with a shorter fault duration reduces phasor accuracy and is therefore counter-productive in an accuracy-focused application such as fault locating.

Addressing evolving faults is another motivation for the embodiments described herein. During an evolving fault, such as when an AG fault evolves into an ABG fault in a few milliseconds, an extra transition in the currents and voltages occurs between the fault inception and breaker operation. As a result, a full-cycle phasor estimator may never stabilize during an evolving fault.

Incipient cable faults (faults that last half a power cycle or just a few half cycles before they clear on their own) pose another fault-locating challenge. If a fault lasts only half a cycle (or less), a full-cycle phasor estimator does not reach a stable response at all. Measuring a current phasor by using only half a cycle of fault data is especially challenging because of the decaying dc component in the fault current. This dc component brings significant uncertainty as to the real magnitude of the fault current if only half a cycle of data is available.

What is needed is a multi-ended fault-locating method that is capable of working on a short fault data window despite transients that occur within that window. Such a method would improve the functioning of an IED by increasing fault-locating dependability and accuracy in phasor-based applications and fault-locating dependability in TW-based applications.

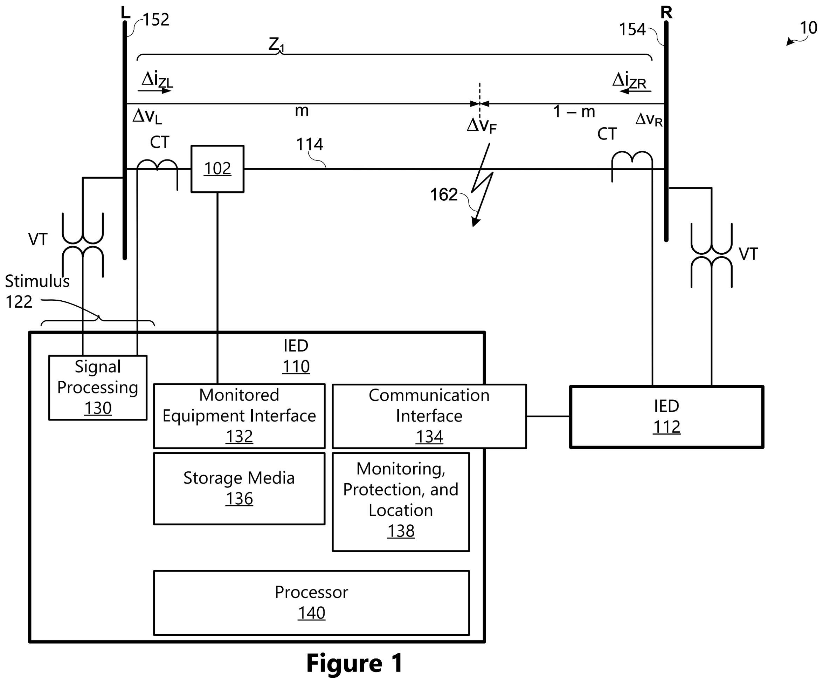

**Figure 1** illustrates a simplified one-line diagram of an electric power delivery system 10 that includes IEDs 110, 112 configured to monitor and protect the power system in accordance with embodiments described herein. The power system includes a local terminal L 152 and a remote terminal R 154 connected by transmission line 114. The system may include various other lines, branches, transformers, loads, and the like, but is illustrated in simplified form for ease of discussion herein. In various embodiments, line 114 may be monitored and protected using a system of IEDs (e.g. IEDs 110, 112). The fault location concepts described herein are implemented using power system signals from the local terminal L 152 and the remote terminal R 154. IEDs 110, 112 may be similar in design and function, and may be in communication for sharing of information. In several embodiments, IED 112 may be implemented as a data-gathering unit such as a merging unit that obtains electric power delivery system signals from the remote terminal R 154, and digitizes and transmits the signals to the IED 110 at the local terminal L 152. In various other embodiments, the fault locating concepts described herein may be performed by a separate IED that receives local and remote power system information from IEDs 110 and 112.

The IED 110 in accordance with certain embodiments herein provides electric power system protection such as differential protection, distance protection, overcurrent protection, and the like, and determines a fault location. The illustrated IED 110 includes a processor 140 for executing computer instructions, which may comprise one or more general purpose processors, special purposes processors, application-specific integrated circuits, programmable logic elements (e.g. , FPGAs), or the like. The IED 110 may further comprise non-transitory machine-readable storage media 136, which may include one or more disks, solid-state storage (*e.g.* , Flash memory), optical media, or the like for storing computer instructions, measurements, settings and the like. In various embodiments the storage media 136 may be packaged with the processor 140, separate from the processor 140, or there may be multiple physical storage media 136 including media packaged with the processor 140 and media 136 separate from the processor 140.

The IED 110 may be communicatively coupled to other IEDs and/or supervisory systems either directly or using one or more communication networks via one or more communication interfaces 134. In some embodiments, the IED 110 may include human-machine interface (HMI) components (not shown), such as a display, input devices, and so on. The communication interface 134 may be in communication with the HMI or other devices. The communication interface 134 may transmit fault information to the HMI for display or to other recipients for use in electric power system maintenance operations.

The IED 110 may include a plurality of monitoring and protection elements, described as a monitoring and protection module 138 that may be embodied as instructions stored on computer-readable media (such as storage media 136). The instructions, when executed on the processor 140, cause the IED to detect a fault and may also cause the IED to execute a protective action in response to the detected fault *(e. g.* signaling a circuit breaker to open the appropriate phases), display fault information, send messages including the fault location, and the like. The displayed fault information may include the distance to the fault from a terminal (or distances to the faults from the terminal), the faulted phase (or phases), the faulted section *(e.g.* of a hybrid or multi-terminal line), information related to the accuracy of the fault location, and the like. The fault information may be transmitted to a utility personnel via email, instant message, telephone, screen display, flag in a SCADA, or the like. Methods disclosed herein may generally follow the instructions stored on media for system protection.

The monitoring, protection, and location module 138 may include protection elements (*e.g.* overcurrent, differential, distance) as well as a fault location module to determine a location of a fault in accordance with the embodiments described herein. The storage media 136 may include protective action instructions to cause the IED 110 to signal a circuit breaker 102 to open via the monitored equipment interface 132 upon detection of a fault condition. It should be noted that in certain embodiments the IED 110 may be configured as a fault locator, where the monitoring, protection, and location module 138 may not include protection functions, but would include a fault location module operating according to the principles described herein.

The IED 110 may obtain electrical signals (the stimulus 122) from the power system 10 through instrument transformers (CTs, VTs, or the like). The stimulus 122 may be received directly via the measurement devices described above and/or indirectly via the communication interface 134 (*e.g.*, from another IED or other monitoring device (not shown) in the electrical power system 10). The stimulus 122 may include, but is not limited to: current measurements, voltage measurements, equipment status (breaker open/closed) and the like.

The IED includes a signal processing module 130 to receive the electric power system signals and process the signals for monitoring and protection such as distance protection. As mentioned above, the signals from the stimulus 122 may be analog (as received directly from instrument transformers), digitized analog signals (as may be received from a merging unit or the like) or digital (as may be received from another IED or the like). Line currents and voltages are sampled at a rate suitable for protection, such as in the order of kHz to MHz. An analog-to-digital converter (ADC) may be included to create digital representations of the incoming line current and voltage measurements. The output of the ADC may be used in various embodiments herein. The signal processing module 130 may provide voltage and current data that is useful for other modules to perform their respective functions. For example, the signal processing module 130 may provide digital voltage and current data for a monitoring and protection module 138 to determine a fault condition, determine a fault location, and the like.

A monitored equipment interface 132 may be in electrical communication with monitored equipment such as circuit breaker 102. Circuit breaker 102 is configured to selectively trip (open). The monitored equipment interface 132 may include hardware for providing a signal to the circuit breaker 102 to open and/or close in response to a command from the IED 110. For example, upon detection of a fault 162 and determining that the fault is within the zone of protection, the monitoring and protection module 138 is configured to determine a protective action and effect the protective action on the power system by, for example, signaling the monitored equipment interface 132 to provide an open signal to the appropriate circuit breaker 102. Upon detection of the fault and determination that the fault is within the zone of protection, the IED 110 may signal other devices (using, for example, the network, or signaling another device directly by using inputs and outputs) regarding the fault, which other devices may signal a breaker to open, thus effecting the protective action on the electric power delivery system.

IED 110 is configured to detect faults on the electric power delivery system, effect a protective action, determine a location of the fault, and provide an indication of the fault location. Accordingly, IED 110 includes protection elements to determine the fault condition, and IED includes a fault location module to determine a fault location and report the fault location. The fault location module is configured to accurately determine a fault location. Indeed, the fault locating module operating in accordance with the embodiments herein improves the functioning of the IED in several respects. The embodiments described herein may use moderate sampling rates and can be deployed in a typical line protective relay that samples on the order of a few kilohertz or offline by using waveforms from a typical digital fault recorder. The embodiments described herein may use only the positive-sequence line impedance to avoid errors associated with the zero-sequence line impedance. The embodiments described herein may use an arbitrary data window size, allowing for windows as short as half a power cycle. The embodiments described herein may be unaffected by the placement of the data window with respect to the fault inception as long as an adequate portion of the data window includes the fault state. The embodiments described herein work without faulted-loop selection logic and therefore perform well for evolving faults, including internal faults at the same location as well as external-to-internal and internal-to-external faults. The embodiments described herein work for high-resistance, intermittent, and arcing faults. The embodiments described herein work for multiterminal lines by identifying the faulted line section and providing the fault location within that section. The embodiments described herein work for hybrid lines comprising overhead line sections and underground cable sections.

Returning to **Figure 1**, IED 110 is configured to determine the location of the illustrated fault 162 relative to the local terminal L 152. The distance to the fault may be expressed as the per-unit fault location m relative to the local terminal L 152 (where 1-*m* represents the per-unit fault location relative to the remote terminal R 154). The complex positive-sequence line impedance is illustrated as $Z_1$.

Consider instantaneous incremental ($\Delta$) voltages and currents at the local (subscript L) and remote (subscript R) terminals. The incremental signals may be obtained by subtracting one- or two-cycle-old values. The subscript Z in $\Delta i_Z$ denotes a replica current, which may be defined as the current obtained by using a unity impedance that mimics the positive-sequence line impedance ($R_1$ is the line resistance and $L_1$ is the line inductance). The incremental replica current may be calculated using Equation 1:

$$\Delta i_Z = \frac{R_1}{|Z_1|} \cdot \Delta i + \frac{L_1}{|Z_1|} \cdot \frac{d}{dt} \Delta i \qquad\qquad \text{Eq. 1}$$

The change in voltage $\Delta v_F$ at the fault location (subscript F) that is m from the local terminal may be calculated by using the local measurements as illustrated in Equation 2:

$$\Delta v_{FL} = \Delta v_L - m \cdot |Z_1| \cdot \Delta i_{ZL} \qquad\qquad \text{Eq. 2}$$

Similarly, the change in voltage $\Delta v_F$ at the fault location (subscript F) that is 1-m from the remote terminal may be calculated by using the remote measurements as illustrated in Equation 3:

$$\Delta v_{FR} = \Delta v_R - (1 - m) \cdot |Z_1| \cdot \Delta i_{ZR} \qquad\qquad \text{Eq. 3}$$

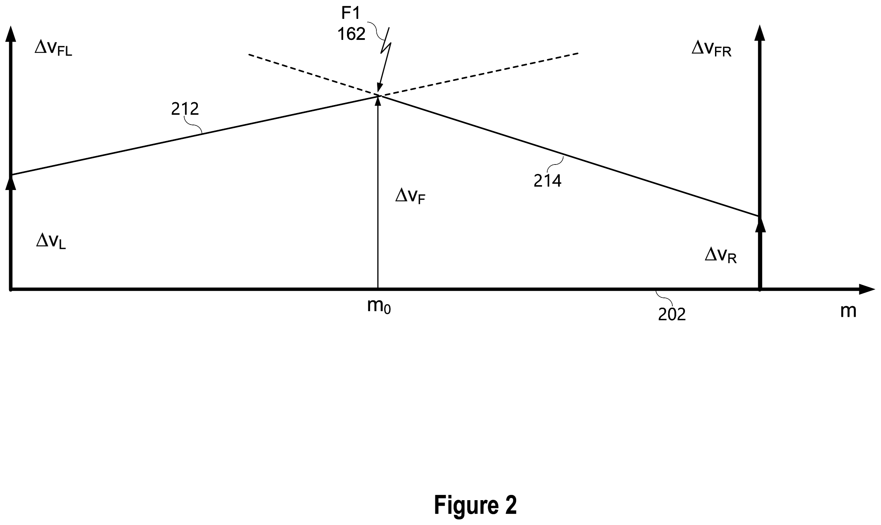

When calculated for the true fault location $m_0$, the values from Equations 2 and 3 match. As illustrated in **Figure 2,** $\Delta v_{FL}$ is plotted (straight line 212) over m (axis 202), and $\Delta v_{FR}$ is plotted (line 214) over m (axis 202). It can be seen that the lines 212 and 214 cross and that point ($m_0$) corresponds with the true fault location 162.

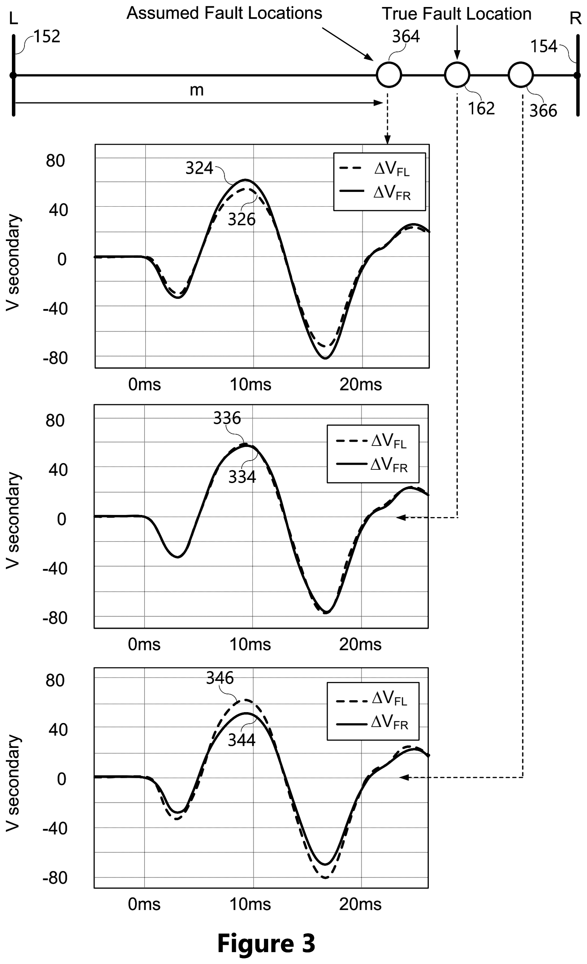

The incremental voltages and incremental replica currents are instantaneous values (samples). Therefore, the change-in-fault-location-voltage signals from Equations 2 and 3 are also instantaneous values and **Figure 2** illustrates a specific point in time. To expand on the time aspect, **Figure 3** shows a power line with a local terminal 152 and a remote terminal 154, and indicates a true fault location 162 on the line. Assuming a first hypothetical fault location 364, we obtain plots of $\Delta v_{FL}$ 326 and $\Delta v_{FR}$ 324 illustrated over time, that do not match completely because the assumed fault location is short of the true fault location. Similarly, at a second assumed fault location 366 we obtain plots of $\Delta v_{FL}$ 346 and $\Delta v_{FR}$ 344 illustrated over time, that do not match completely because the assumed fault location is beyond the true fault location. At the true fault location 162 plots of $\Delta v_{FL}$ 336 and $\Delta v_{FR}$ 334 are illustrated over time, and it can be seen that these are a good match.

The change-in-fault-location-voltage signals develop from zero and reflect the change in voltage from pre-fault to fault values, including transients. The estimate from the local terminal (Equation 2) and the remote terminal (Equation 3) match for the true fault location, irrespective of the transients related to the resistive-inductive nature of the power line. It is, however, beneficial to pass signals from Equations 2 and 3 through a low-pass filter to remove signal components that do not depend on the fault location, such as oscillations related to the line capacitance. For example, IEDs may use second-order filters that attenuate their input signals by -20 dB at 0.4 kHz.

A method for calculating a minimizing difference between Equations 2 and 3 may be used to calculate the actual fault location $m_0$. Equation 4 uses the Least Errors Squared (LES) algorithm to calculate $m_0$ by minimizing the difference between Equations 2 and 3 over a time window Tw:

$$\sum_{T_W} (\Delta v_{FL}(m) - \Delta v_{FR}(m))^2 \rightarrow \text{Minimum with respect to m} \qquad \text{Eq. 4}$$

Equations 2 and 3 may be inserted into Equation 4, and then solved for $m_0$ as follows in Equations 5-7:

$$m_0 = \frac{S_N}{S_D} \qquad \text{Eq. 5}$$

Where the numerator and denominator sums are:

$$S_N = \sum_{T_W} \left( \frac{\Delta v_L - \Delta v_R}{|Z_1|} + \Delta i_{ZR} \right) \cdot (\Delta i_{ZL} + \Delta i_{ZR}) \qquad \text{Eq. 6}$$

$$S_D = \sum_{T_W} (\Delta i_{ZL} + \Delta i_{ZR})^2 \qquad \text{Eq. 7}$$

Equations 5, 6, and 7 define a fault-locating method in accordance with several embodiments. These equations involve sums over a time window $T_W$ of expressions that combine samples of the local and remote incremental voltages and incremental replica currents.

The traditional approach to impedance-based fault locating requires using the voltage and current of the faulted loop. For example, fault locators use the AG loop for A-phase-to-ground faults and the AB loop for A-phase-to-B-phase faults. The embodiments described herein can be applied in this way by using the instantaneous loop voltages and currents.

Unlike traditional impedance-based methods, the embodiments herein do not require faulted-loop selection logic and can be applied by using only the phase-to-phase loops. The phase-to-phase voltages at the fault location change for both phase-to-ground and phase-to-phase faults. For example, during an AG fault, the AG, AB, and CA voltages change significantly. Equations 5, 6, and 7 can be applied to the AG loop, the AB loop, and the CA loop and will yield nearly identical results. Therefore, embodiments herein can use the phase loops for all fault types, including single-phase-to-ground faults.

Using only phase loops improves accuracy by not having to rely on the zero-sequence line impedance, which is typically less accurate than the positive-sequence line impedance. The zero-sequence line impedance depends on soil resistivity along the line path at the time of the fault. Additionally, mutual coupling with parallel lines, rail tracks, and pipelines affects the zero-sequence voltage and current components.

Faulted-loop selection logic may be avoided by redefining the LES approach (Equation 4) to include the sum of differences between the local and remote change-in-fault-location-voltage estimates in the $\Phi\Phi$ (phase-to-phase) loops as follows:

$$\sum_{\Phi\Phi=AB}^{CA} \sum_{T_W} (\Delta v_{FL\Phi\Phi}(m) - \Delta v_{FR\Phi\Phi}(m))^2 \rightarrow \text{Minimum with respect to m} \qquad \text{Eq. 8}$$

where $\Phi\Phi$ is AB, BC, or CA.

The LES problem in Equation 8 may be solved to obtain the numerator ($S_N$) and denominator ($S_D$) illustrated in Equations 9 and 10 respectively:

$$S_N = \sum_{\Phi\Phi=AB}^{CA} \sum_{T_W} \left( \frac{\Delta v_{L\Phi\Phi} - \Delta v_{R\Phi\Phi}}{|Z_1|} + \Delta i_{ZR\Phi\Phi} \right) \cdot (\Delta i_{ZL\Phi\Phi} + \Delta i_{ZR\Phi\Phi}) \qquad \text{Eq. 9}$$

$$S_D = \sum_{\Phi\Phi=AB}^{CA} \sum_{T_W} (\Delta i_{ZL\Phi\Phi} + \Delta i_{ZR\Phi\Phi})^2 \qquad \text{Eq. 10}$$

Equations 5, 9, and 10 illustrate one embodiment of the fault-locating methods described herein. These equations involve sums - over a time window Tw and over all three phase loops - that combine samples of the local and remote phase-to-phase incremental voltages and phase-to-phase incremental replica currents.

Methods described above may be further expanded, remembering that they match the change-in-fault-location-voltage signals, and they will continue to work if they match fractions of these signals, such as the phase voltages minus the zero-sequence voltage. Equations 5, 9, and 10 match the phase-to-phase voltages, which may be described as scaled beta Clarke components. This method can also match the alpha components (phase components minus the zero-sequence or ground component), and by doing so, it would eliminate the impact of the zero-sequence line impedance errors. Yet another method can use Equations 5, 9, and 10 and sum all six aerial components (three alpha components and three beta components) instead of the three phase-to-phase (beta) components.

It should be noted that the denominator (Equation 10) is never zero for internal faults because it reflects current that flows through the fault path at the fault location. As a result, the method is numerically robust and stable.

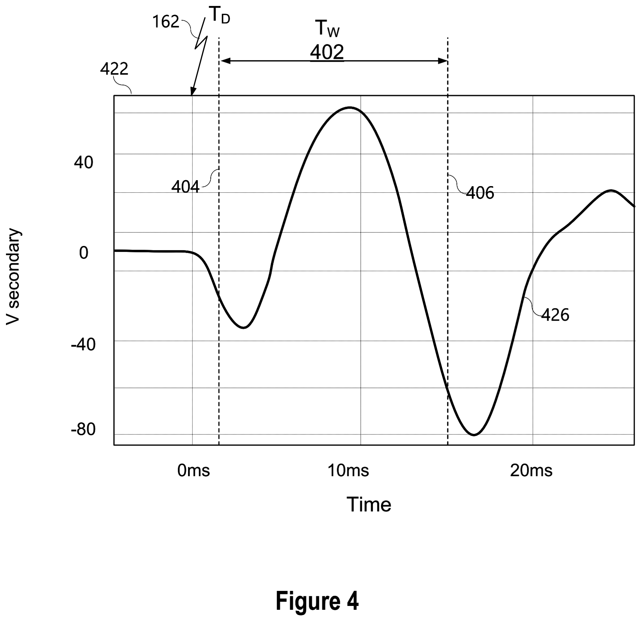

As mentioned above, embodiments herein allow for flexible selection of the beginning ($T_D$) 404 and length ($T_W$) 402 of the data window. **Figure 4** illustrates a plot 422 of change-in-voltage (secondary) over time during a fault 162. A data window $T_W$ 402 starting at $T_D$ 404 and ending some time later 406 includes the data that may be used to determine the fault location in accordance with several embodiments herein.

In various embodiments, the data window is started a few milliseconds into the fault. This delay allows for purging the data window from transients that do not depend on the fault location. These transients are primarily the high-frequency components in the voltage signals and the step response of the low-pass filters that the fault-locating devices use when acquiring voltages and currents. Also, capacitively coupled voltage transformers (CCVTs) exhibit a low-pass frequency response and smooth the falling edge of the voltage following fault inception. Avoiding the first one or two milliseconds of data allows this CCVT artifact to be left out of the input data used for fault location. In various embodiments, the change-in-fault-location-voltage signal develops from zero and therefore is relatively small in the first few milliseconds after the fault inception. Additionally, the aforementioned transients tend to partially average out over time and due to similarity between the local and remote signals. As a result, the initial data do not significantly affect the LES sums and delaying the data window is beneficial but not strictly required. Accordingly, in various embodiments the data window may be started at fault inception or even before the fault inception.

The length of the data window ($T_W$) should be shorter than the shortest possible fault duration. In applications with phasor-based relays, consider using Tw = 2 cycles. In applications with transient-based UHS relays, consider using $T_W$ = 1 cycle. In applications to locate incipient cable faults, consider using $T_W$ = 0.5 cycle. Of course, the window length does not need to be a multiple of half a cycle. Also, the window does not need to perfectly envelop the fault interval. The impact of starting the window too early or closing it too late is negligible.

The data window length can be adaptive. For example, the fault-locating logic can close the data window 1 cycle after the relay has issued the trip command, i.e. before even the fastest breaker can open. Alternatively, the logic can analyze the current waveform to detect the time of the breaker open-pole condition and close the data window just before the open-pole condition occurs.

In various embodiments, a *goodness of fit* value $\varepsilon$ may be introduced for the purpose of approximating the quality of the fault location. The square root of the LES value may be used, and normalized, not with respect to the highest value for any assumed fault location but with respect to the rms magnitudes of the change-in-fault-location-voltage signals, as follows in Equation 11:

$$\varepsilon = \frac{S_A}{S_B} \cdot 100\% \qquad \text{Eq. 11}$$

where:

$$S_A = \sqrt{\sum_{\Phi\Phi=AB}^{CA} \sum_{T_W} (\Delta v_{FL\Phi\Phi}(m_0) - \Delta v_{FR\Phi\Phi}(m_0))^2} \qquad \text{Eq. 12}$$

$$S_B = \sqrt{\sum_{\Phi\Phi=AB}^{CA} \sum_{T_W} \Delta v_{FL\Phi\Phi}(m_0)^2} + \sqrt{\sum_{\Phi\Phi=AB}^{CA} \sum_{T_W} \Delta v_{FR\Phi\Phi}(m_0)^2} \qquad \text{Eq. 13}$$

The goodness of fit value, $\varepsilon$, is a Euclidean distance between the two change-in-fault-location-voltage signals in per unit of the Euclidean norms of these signals. By using this definition, all potential fault locations do not need to be considered, but instead only the location obtained from the "goodness of fit" method ($m_0$) needs be considered.

The $\varepsilon$ value is always between 0 and 100 percent. $\varepsilon = 0$ if the two signals are identical (perfect fit, maximum similarity). $\varepsilon = 100$ if the two signals are as different as possible (identical in value and opposite in polarity, maximum dissimilarity).

To develop an intuitive understanding of $\varepsilon$, consider that if the local and remote change-in-fault-location-voltage estimates differ on average by 1 percent, the $\varepsilon$ value is about 0.5 percent. An elevated $\varepsilon$ value can indicate the following issues: CCVT transients that make the shape of the incremental voltages different between the terminals, CT saturation that makes the shape of the incremental replica currents different between the terminals, large capacitive charging current (as compared to the fault current) that makes the method less accurate, and large line-side reactor currents (as compared to the line current) that similarly make the method less accurate. The $\varepsilon$ value may provide a degree of confidence for the accuracy of the fault-locating result, but it cannot be solely relied on as a true accuracy indicator. That is, it can be generally expected that a low $\varepsilon$ value is consistent with an accurate fault-locating result. However, there may be cases where the fault location is highly accurate even though the $\varepsilon$ value is high and vice versa. It is good practice to inspect the relay signals if the $\varepsilon$ value is greater than about 2 percent.

In one example, a fast-clearing fault yields an $\varepsilon$ value of 1.4 percent, which indicates a high quality of the fault-locating result. Of course, the accuracy may be affected by errors in the line impedance setting or the line length setting, but the 1.4 percent value implies that the performance of the method was nearly perfect given the measurements and settings.

In another example, the embodiments herein were applied to a system that experienced an AG fault that evolved after 11 ms into an ACG fault. The embodiments calculated a fault at 27.706 miles, where the true fault location was found to be at 27.638 miles, whereas traditional phasor-based methods would have trouble locating the fault due to the fault evolving from AG to ACG in 11ms, which would not allow the phasors to stabilize during the first fault. Accordingly, the embodiments herein improve the functioning of an IED.

The embodiments applied to an incipient fault also demonstrate improvements in functioning of an IED. In one example, an incipient fault on the C phase was detected and located at 185.47 km from the local terminal, where the true event location was 195.83 km, which is a 2.9 percent difference based on line length of 352.58 km. Incipient faults are not generally detectable using traditional phasor-based methods.

The embodiments herein have also been applied to arcing high-resistance faults. In one example, an arcing high-resistance BG fault was detected at 23.79 mi from the terminal using the methods herein. The true fault location was at 24.6 mi from the terminal. A traditional phasor-based fault-locating method would face challenges for this fault. The phasors do not stabilize because the voltage and current phasors keep changing, and the high fault resistance adds other challenges. For example, the traditional single-ended impedance-based method reported the fault location as 36.522 mi (an error of 17 percent of the line length). The fault resistance and the nonstationary nature of the current cause this large error. Thus, the embodiments herein result in an improvement in the functioning of an IED.

The embodiments herein have also been applied to a fault during a single-pole-open condition. In one such event, phase C was open, an AG fault occurred on a 28.4 km line. The embodiments herein calculated a fault location at 3.01 km at the terminal, where the true fault location was found to be at 3.267 km from the terminal. During the C-phase open condition, the method processes only the AB loop to avoid using the C-phase voltage because this voltage is not related to the fault location, especially if the relay is connected to bus-side VTs or the line has line-side reactors installed.

Because of the open-pole condition, single-ended phasor-based fault-locating methods would face challenges because they cannot use any of the typical polarizing signals, such as the negative-sequence current. Thus, the embodiments herein improve the functioning of an IED.

The method is based on voltages and currents, and therefore the instrument transformer and relay input errors affect the fault-locating accuracy. However, because the method is a double-ended method and it uses measurements from three phase-to-phase loops, these errors have a high probability of partially canceling (the method uses 12 signals - 3 local and 3 remote voltages, and 3 local and 3 remote currents - irrespective of the fault type).

Embodiments herein are effective even under external fault conditions. External unbalance does not upset the voltage-drop Equations 2 and 3. Specifically, an external fault could occur immediately before, simultaneously with, or immediately after the internal fault, and the embodiments herein will perform well despite the external fault. Similarly, if a switching event occurs immediately before, simultaneously with, or immediately after the internal fault, the voltage-drop Equations 2 and 3 hold, and the embodiments herein yield sufficiently accurate fault locations.

Two simultaneous or nearly simultaneous internal faults at different locations is another special case to consider. Such faults could happen as a result of back flashover during lightning strikes or because of the voltage swell in the healthy phases as a result of the initial single-phase-to-ground fault. The methods described herein can be used to detect the presence of two internal faults. When applied to loops that involve faulted phases, the method yields similar results in each loop as long as there is only one fault in a particular location. If different loops yield different results, it is likely that the line has two or more simultaneous faults at different locations. Calculating the fault location separately for all six loops (three at the local terminal, and three at the remote terminal) may allow both fault locations to be determined.

Current transformer (CT) saturation errors and CCVT transient errors are significantly higher than ratio errors, and therefore they impact the fault-locating accuracy to a higher degree. The embodiments herein can be enhanced to avoid using fault loops that contain significant CT or CCVT errors. For example, if the A-phase CT saturates during an AB fault, the method can use the BC loop instead of all three loops, and by doing so, it avoids using the A-phase current from a saturated CT.

The embodiments herein use the local and remote voltages and currents where these two data sets are time-aligned. A data alignment error may affect the fault-locating accuracy. However, owing to the relative homogeneity of the incremental-quantity equivalent network, especially for the phase loops, one may correct the method for the data misalignment. In homogeneous networks, the change-in-fault-location-voltage signals calculated from the local and remote terminals are in phase, and one may just shift the remote signal to align with the local signal before matching the incremental signal magnitudes by using the LES algorithm. Further below methods to detect and compensate for poor alignment is discussed.

Line impedance errors affect fault-locating accuracy. The embodiments herein avoid using the zero-sequence line impedance for ground faults, and as a result, have better accuracy (no impact from soil resistivity and mutual coupling). Using all three phase loops for all fault types allows the embodiments to average (at least partially) errors related to line transposition. The voltage-drop equations 2 and 3 neglect the line capacitance, potentially resulting in a small error. Applying low-pass filtering to the change-in-fault-location-voltage signals remediates this issue to a great degree (all examples in this application apply low-pass filtering). Additionally, the voltage-drop equations 2 and 3 can be expanded to approximate the line charging current in the time domain and further improve the fault-locating accuracy, which may be beneficial for very long lines. Similarly, the method can be re-arranged to use a long-line model rather than the lumped-parameter model as per Equations 2 and 3.

Fault records for external faults may be used to fine-tune the line impedance magnitude. To apply this concept to our method, the value of $|Z_1|$ may be found that minimizes the LES difference between two voltage values: 1) the measured change in voltage at the remote terminal and 2) the change in voltage at the remote terminal calculated from the change in voltage at the local terminal and the line incremental replica current. This process results in Equation 14:

$$|Z_1| = \frac{S_P}{S_Q} \qquad\qquad \text{Eq. 14}$$

where:

$$S_P = \sum_{\Phi\Phi=AB}^{CA} \sum_{T_W} (\Delta v_{L\Phi\Phi} - \Delta v_{R\Phi\Phi}) \cdot (\Delta i_{ZL\Phi\Phi} - \Delta i_{ZR\Phi\Phi}) \qquad \text{Eq. 15}$$

$$S_Q = \frac{1}{2} \cdot \sum_{\Phi\Phi=AB}^{CA} \sum_{T_W} (\Delta i_{ZL\Phi\Phi} - \Delta i_{ZR\Phi\Phi})^2 \qquad \text{Eq. 16}$$

In the above equations, half of the difference of the local and remote currents may be used for better accuracy (for external faults, the two currents are ideally identical in value and opposite in polarity).

Using external faults to fine-tune the line impedance magnitude can improve the overall experience over the fault locator installation lifespan. However, Equations 14, 15, and 16 yield numerically accurate results only if the incremental voltage drop across the line is sufficiently above the VT and relay voltage measurement errors. Before using the equations to fine-tune the $|Z_1|$ magnitude, the difference between the local and remote terminals in the incremental phase-to-phase voltages that include the faulted phase(s) should be greater than 10 percent of the nominal voltage.

The methods described herein are not affected by line terminations. A special termination case is a line-end-open condition. A double-ended TW-based fault-locating method that is based on current would fail in this case. Of course, the single-ended impedance-based method at the line end with a closed breaker would work reasonably well because there is no infeed effect from the open line terminal. The embodiments herein work well as long as the voltage is measured on the line side of the open breaker as is typically the case in high-voltage applications. As expected, the voltage rise along the line due to the line capacitance may degrade the accuracy of fault locating to some degree.

Naturally, the embodiments herein work well if one of the terminals is very weak (very small change in current and voltage as opposed to no change in current). Note, however, that faults always cause some change in either voltage or current, even if the terminal connects only loads and not sources.

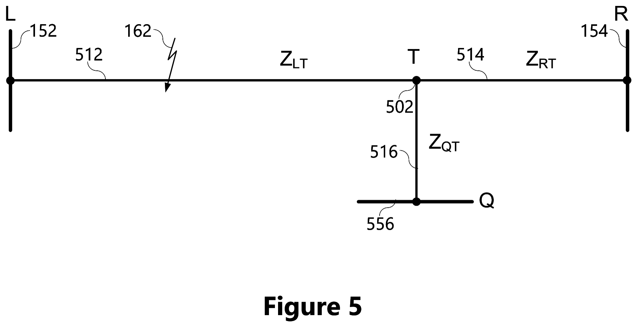

Embodiments herein may also be applied to multi-terminal lines. **Figure 5** illustrates a three-terminal line with terminals L 152, R 154, and Q 556, and a fault 162 between terminal L 152 and tap point T 502 which connects the line to terminal Q 556. The line includes three sections: LT 512, RT 514, and QT 516. Generally, the following procedure may be used to apply the embodiments herein to a multi-terminal line:

1) Identify the faulted section by matching the change-in-voltage signals at the line tap location(s).
2) Calculate the incremental voltages and incremental replica currents at the terminals of the faulted section.
3) Apply the two-terminal method described above to the faulted line section.

The method calculates the change-in-voltage-at-the-tap (T) signals, assuming all line sections are healthy:

$$\Delta v_{TL} = \Delta v_L - |Z_{LT}| \cdot \Delta i_{ZL} \qquad \text{Eq. 17}$$

$$\Delta v_{TR} = \Delta v_R - |Z_{RT}| \cdot \Delta i_{ZR} \qquad \text{Eq. 18}$$

$$\Delta v_{TQ} = \Delta v_Q - |Z_{QT}| \cdot \Delta i_{ZQ} \qquad \text{Eq. 19}$$

For the case shown in **Figure 5,** Equations 18 and 19 yield very similar values but Equation 17 yields a different value because the fault makes Equation 17 inaccurate. These results confirm that section LT is faulted and sections RT and QT are healthy. To compare the change-in-voltage-at-the-tap signals, use the squared differences between Equations 17, 18, and 19 over the same data window as in the fault-locating calculations. For example, to compare Equations 17 and 18, use Equation 20:

$$\sum_{\Phi\Phi=AB}^{CA} \sum_{T_W} (\Delta v_{TL\Phi\Phi} - \Delta v_{TR\Phi\Phi})^2 \qquad \text{Eq. 20}$$

Knowing that the LT section is faulted, the method calculates the incremental voltage and incremental replica current at the tap T of the faulted section as follows in Equations 21 and 22:

$$\Delta v_T = \frac{1}{2}\left(\Delta v_{TR} + \Delta v_{TQ}\right) \qquad\qquad \text{Eq. 21}$$

$$\Delta i_T = \Delta i_R + \Delta i_Q \qquad\qquad \text{Eq. 22}$$

Equation 21 averages the two voltage calculations from the R and Q terminals to provide additional accuracy (the two values being averaged are ideally the same). Equation 22 follows Kirchhoff's current law for the node T. Use the faulted section (LT) impedance to calculate the replica current based on the current as per Equation 22.

Finally, the method applies the two-terminal procedure described earlier in this disclosure to the signals labeled L and T while using the $Z_{LT}$ line section impedance. The fault-locating result is in per unit of the faulted line section LT.

When the line sections are not homogeneous (e.g., they have different X/R ratios), obtain the replica currents Equation 1 and use the corresponding line section impedance: $Z_{LT}$ in Equation 17, $Z_{RT}$ in Equation 18, $Z_{QT}$ in Equation 19, and $Z_{LT}$ in Equation 22.

Embodiments herein may be applied to underground or undersea cables. Underground or undersea cables differ from overhead lines in many respects. On the basis of per unit of length, they have lower impedance but draw higher capacitive charging current. In single-core cables, all conductors are shielded as a group. In three-core cables, each phase conductor is shielded separately. The shields may be bonded and grounded along the cable path. As a result, the zero-sequence representation of a cable may differ from that of an overhead line. Phase faults in single-core cables are practically impossible, and most faults are ground faults. Phase-to-phase mutual impedances in single-core cables are practically zero.

Differences between cables and overhead lines are of degree and not kind. An overhead line operates with ground under the conductors and in the presence of a shield wire that may also be grounded along the line path. Both a cable and an overhead line may be represented using the same line impedance matrix, except the matrix for a cable has significantly different values than the matrix for an overhead line. Owing to this mathematical similarity, the embodiments herein work for phase-to-phase loops to locate ground faults in cables.

Moreover, by avoiding the zero-sequence line impedance and voltage and current components, the method has better accuracy than traditional fault-locating methods that work with ground loops.

Indeed, the embodiments described herein have been applied to a 9.40 mi underground cable experiencing a BG fault. The embodiments determined a fault location of 9.121 mi from the local terminal, where the true fault location was at the remote terminal.

The embodiments herein may be applied to hybrid lines, which include overhead line (OHL) sections and underground cable (UGC) sections. The following steps may be used to apply the embodiments herein to hybrid lines:

1) Assume a faulted section of the line.
2) Calculate the incremental voltages at both terminals of the faulted line section by using the local and remote voltages and currents.
3) Apply the two-terminal method to the faulted line section.
4) Determine if the calculated fault location falls within the assumed line section (step 1). If it does, the true fault location is found. If it does not, return to step 1 of this procedure and assume a different faulted section, progressing along all line sections.

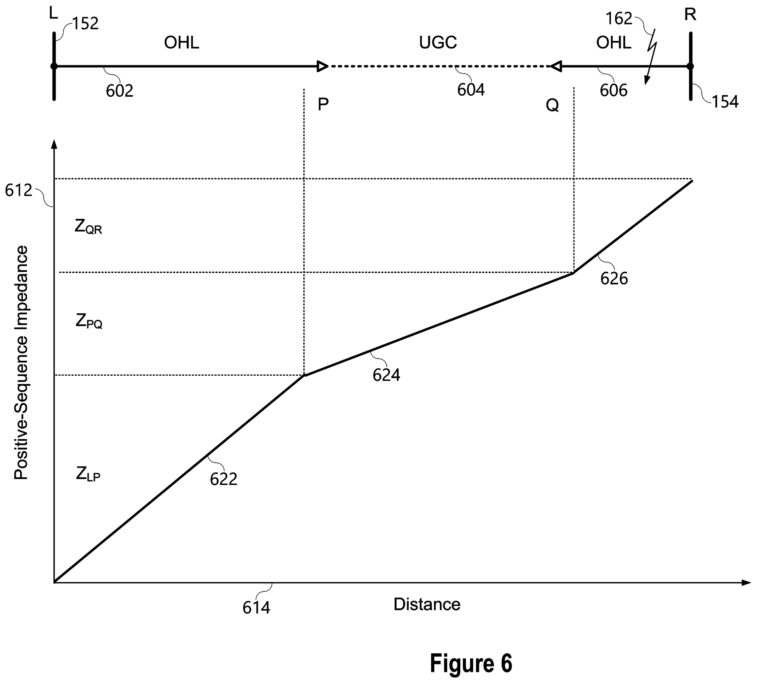

Consider the hybrid line with two overhead line sections 602, 606 and one underground cable 604 section shown in **Figure 6.** Also illustrated is a plot of positive-sequence impedance magnitude 612 over the distance 614 of the line. As can be seen, the positive-sequence impedance magnitude $Z_{LP}$ for the first overhead section 602 exhibits a first slope 622 over the distance; the positive-sequence impedance magnitude $Z_{PQ}$ for the underground section exhibits a second slope 624 over distance, different from the first slope 622, and the positive-sequence impedance magnitude $Z_{QR}$ for the second overhead section 606 exhibits a third slope 626 over the distance (which may be similar to the slope 622, and may be different from slope 624).

Because hybrid lines are nonhomogeneous, the replica incremental currents derived from the measured local and remote currents may be used to calculate the incremental voltages along the line segments. Instead, when calculating the incremental voltages, the impedance between the relay location and the point of interest must be accounted for. Similarly, when calculating the replica incremental currents, the impedance of the assumed faulted section should be used. Consider the following example.

The fault is assumed to be located on the LP section of the line shown in **Figure 6.** The change in voltage at the L

terminal $\Delta v_L$ is a measured value. The change in voltage at the P junction may be calculated from the remote voltage and current measurements as follows in Equation 23:

$$\Delta v_{PR} = \Delta v_R - \cdots$$

$$\left( \left( R_{QR} + R_{PQ} \right) \cdot \Delta i_R + \left( L_{QR} + L_{PQ} \right) \cdot \frac{d}{dt} \Delta i_R \right) \qquad \text{Eq. 23}$$

The two-terminal method may be applied by using the $\Delta v_L$ voltage, the $\Delta v_{PR}$ voltage in Equation 23, and the $\Delta i_L$ and $\Delta i_R$ currents (when calculating the incremental replica currents in step 3, using the $Z_{LP}$ impedance), and calculate the fault location $m_0$ in per unit of the LP section length. For the case shown in **Figure 6,** the calculated $m_0$ is greater than 1 pu, indicating that the fault is not on the LP section of the line.

Knowing the fault is not on the LP section, the fault is assumed to be on the PQ section of the line and calculate the change in voltage at the P and Q junctions from the local and remote voltage and current measurements as follows in Equations 24 and 25:

$$\Delta v_{PL} = \Delta v_L - \left( R_{LP} \cdot \Delta i_L + L_{LP} \cdot \frac{d}{dt} \Delta i_L \right) \qquad \text{Eq. 24}$$

$$\Delta v_{QR} = \Delta v_R - \left( R_{RQ} \cdot \Delta i_R + L_{RQ} \cdot \frac{d}{dt} \Delta i_R \right) \qquad \text{Eq. 25}$$

The two-terminal method may be applied by using the $\Delta v_{PL}$ voltage Equation 24, the $\Delta v_{QR}$ voltage Equation 25, and the $\Delta i_L$ and $\Delta i_R$ currents (when calculating the incremental replica currents in step 3, using the $Z_{PQ}$ impedance), and calculate the fault location $m_0$ in per unit of the PQ section length. For the case shown in **Figure 6,** the calculated $m_0$ is greater than 1 pu, indicating that the fault is not on the PQ section of the line.

Finally, the fault may be assumed to be located on the QR section of the line. The change in voltage at the R terminal $\Delta v_R$ is a measured value. The change in voltage may be calculated at the Q junction from the local voltage and current measurements as follows in Equation 26:

$$\Delta v_{QL} = \Delta v_L - \cdots$$

$$\left( \left( R_{LP} + R_{PQ} \right) \cdot \Delta i_L + \left( L_{LP} + L_{PQ} \right) \cdot \frac{d}{dt} \Delta i_L \right) \qquad \text{Eq. 26}$$

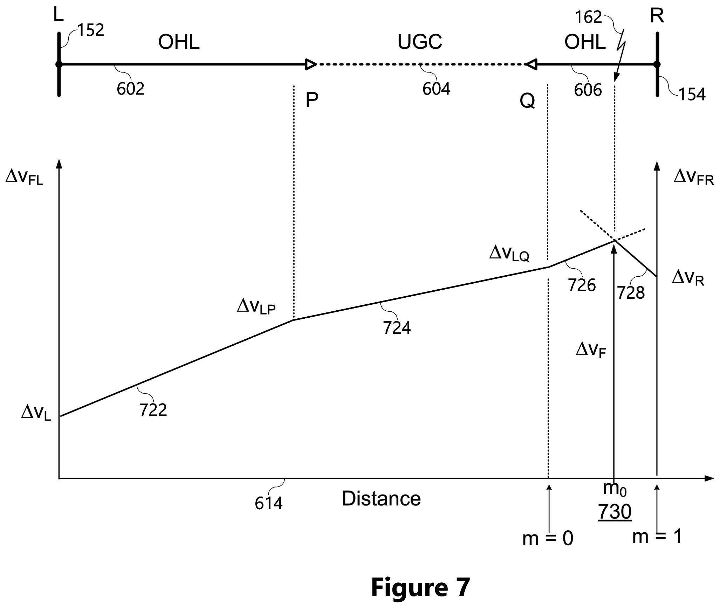

The two-terminal method may be applied by using the $\Delta v_R$ voltage, the $\Delta v_{QL}$ voltage in Equation 26, and the $\Delta i_L$ and $\Delta i_R$ currents (when calculating the incremental replica currents in step 3, we use the $Z_{QR}$ impedance), and calculate the fault location $m_0$ in per unit of the QR section length. For the case shown in **Figure 6,** the calculated $m_0$ is between 0 pu and 1 pu, indicating that the fault is on the QR section of the line. **Figure 7** illustrates the voltage change profile 722, 724, 726 calculated from the local terminal 152 and the voltage change profile 728 calculated from the remote terminal, wherein the intersection of the profiles corresponds with the true fault location $m_0$ 730.

As suggested above, local and remote records that are not time-aligned may be used in the embodiments described herein. The fault acts as a synchronizing event because the incremental signals rise from zero in the pre-fault state to non-zero values at the fault inception.

Disturbance-detection logic may be used to obtain a coarse alignment of the local and remote records. Subsequently, the LES calculations may be repeated multiple times, shifting the remote data set by as much as ±1 or ±2 ms in steps of one sample to obtain the minimum possible LES value.

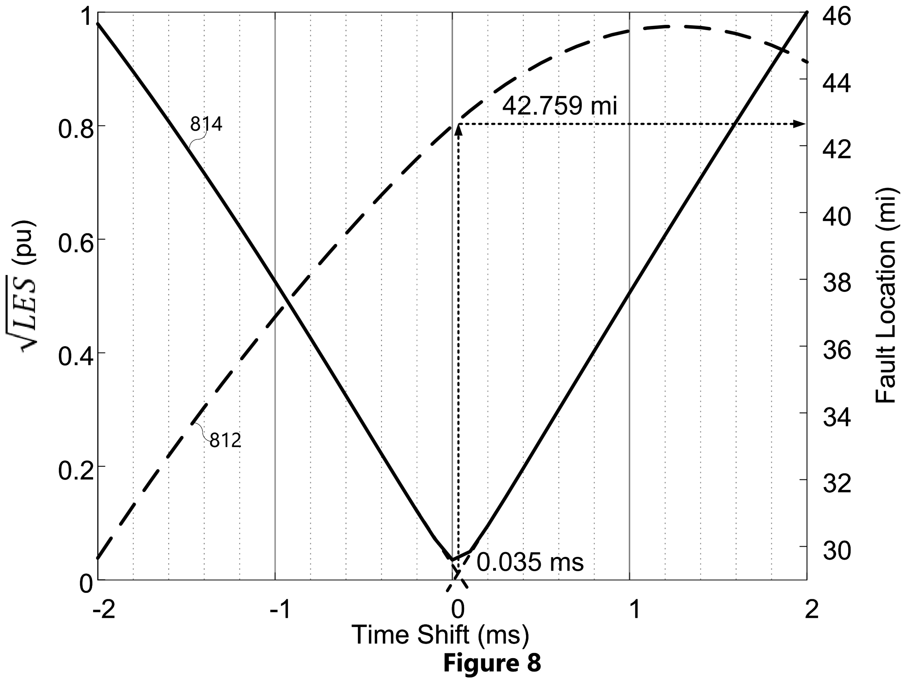

The plots in **Figure 8** illustrate this process. The fault locations 812 and the normalized square root of the LES values 814 may be calculated for each time shift 802. Notice that when the time shift is restricted to be only in increments of the sampling period (0.1 ms in this case), the minimum LES value occurs when the time shift is 0 ms. However, interpolation may be used when searching for the minimum LES value to improve the data alignment and reach a time resolution better than one sampling period. To perform interpolation, a parabola or a tent shape may be fitted to the LES value as a function of the time shift and find the minimum of the fitted shape. The minimum LES value is determined from the intersection point of the two best fit straight lines that use data points on the left and right of the minimum, respectively. Finally, that interpolated time shift may be used in fractional samples to interpolate the fault location.

The LES value is at its minimum for a time shift of 0.035 ms. The original record comes from a scheme with the worst-case time alignment accuracy of 200 ns and typical accuracy of 50 ns. The 200 ns worst-case timing error is negligible compared with the 0.035 ms time shift. Therefore, we can use the 0.035 ms value as an error of the time alignment method described above. This error is very small illustrating the power of the time alignment method described above.

The alignment method is robust because manipulating the m value for a time-shifted record cannot accurately match the change in voltage at the fault location calculated from the local and remote terminals. Instead, the best fit can only be obtained by correctly time-shifting the records before manipulating the m value. As a result, the time shift that minimizes the LES value is the shift that correctly aligns the local and remote records.

The presented alignment method allows faults to be located by using records that are not time-aligned. In the example illustrated in **Figure 8,** the fault location that corresponds to the minimum LES value at 0.035 ms is 42.759 mi (interpolated m value). Fault locating performed on the aligned data yielded 42.603 mi, and the utility-confirmed location was 41.91 mi. To summarize, using records that were not time-aligned introduced an error of only 0.156 mi (823 ft or 251 m).

The fault-locating method that seeks to minimize the LES value by considering both the fault location and the time-shift as variables allows detection and compensation for poor alignment in installations that are expected to provide time-aligned fault records.

In general, the fault-locating methods described herein may be used by assuming both the fault location and the time-shift as variables. This approach may be beneficial for very long lines with long TW propagation times. For faults on long lines, the TWs that are the first indicators of the disturbance may arrive at the opposite line terminals at times as different as 1 ms, creating an impression of data misalignment. Treating the time-shift as a variable in these cases allows us to bridge the gap between the actual line with finite and significant TW propagation times and the lumped-parameter line model used to derive the fault-locating method.

As mentioned above, the fault location methods described herein may be performed in an IED of an electric power delivery system. The IED may also perform protection functions for the electric power delivery system, such as IED 110. The IED may receive voltage and current signals from the power system using, for example, instrument transformers or the like. In other embodiments, the IED 110 may receive digitized analog voltage and current signals (or even communications that include voltage and current data) from another IED, merging unit, or the like. In various other embodiments, the fault location methods described herein may be performed in an IED configured as a fault locator that receives voltage and current data related to the local and the remote terminals, and uses the voltage and current data to determine a fault location. In one example, IEDs 110 and 112 transmit voltage and current data to a fault locator, which uses the local and remote voltage and current data to determine a fault location, and report the fault location such that personnel may address the fault on the electric power delivery system.

While specific embodiments and applications of the disclosure have been illustrated and described, it is to be understood that the disclosure is not limited to the precise configurations and components disclosed herein. Moreover, principles described herein may also be utilized for distance protection and directional overcurrent protection. Accordingly, many changes may be made to the details of the above-described embodiments without departing from the underlying principles of this disclosure. The scope of the present invention should, therefore, be determined only by the following claims.

## Claims

1. An apparatus to determine a location of a fault in an electric power delivery system that comprises a local location and a remote location electrically connected by a line, the apparatus comprising:

   a signal processing subsystem to produce

       a plurality of local current data and voltage data related to the local location of the electric power delivery system and;
       a plurality of remote current data and voltage data related to the remote location of the electric power delivery system;

   a fault location module in communication with the signal processing subsystem configured to:

       determine local incremental voltages and replica currents related to the local location using the plurality of local current and voltage data;

determine remote incremental voltages and replica currents related to the remote location using the plurality of remote current and voltage data; and

determine a fault location as corresponding with a value that minimizes a difference between a function of the local incremental voltages and replica currents and a function of the remote incremental voltages and replica currents; and,

a communication interface to transmit the determined fault location to a user.

2. The apparatus of claim 1, wherein:

the function of the local incremental voltages and replica currents comprises a change-in-voltage at the fault location over a range of per-unit fault locations;

the function of the remote incremental voltages and replica currents comprises a change-in-voltage at the fault location over the range of per-unit fault locations; and

the fault location is determined as a per-unit fault location value which minimizes a difference between the function of the local incremental voltages and replica currents and the function of the remote incremental voltage and replica currents.

3. The apparatus of claim 2, wherein:
the apparatus determines the per-unit fault location value which minimizes the difference is calculated using sums of the first change-in-voltage and the second change-in-voltage over a time window.

4. The apparatus of claim 3, wherein the time window starts after inception of a fault.

5. The apparatus of claim 3, wherein the time window is not limited to one power cycle or multiples of a power cycle.

6. The apparatus of claim 3, wherein the time window persists until a time of an open-pole condition.

7. The apparatus of claim 1 wherein, irrespective of the fault type:

the local current data and voltage data comprise phase-to-phase currents and phase-to-phase voltages; and
the remote current data and voltage data comprise phase-to-phase currents and phase-to-phase voltages.

8. The apparatus of claim 6, wherein:

the electric power delivery system comprises three phases; and
the phase-to-phase currents and phase-to-phase voltages comprise all three two-phase combinations of the three phases.

9. The apparatus of claim 8, wherein:

the electric power delivery system comprises a second fault at a second fault location internal to the electric power delivery system; and
the second fault location is determined as corresponding with a value that minimizes a difference between:

a function of the local phase-to-phase incremental voltages that include a phase of the second fault and phase-to-phase replica currents that include the phase of the second fault and
a function of the remote phase-to-phase incremental voltages that include the phase of the second fault and phase-to-phase replica currents that include the phase of the second fault.

10. The apparatus of claim 8, wherein:

the electric power delivery system comprises three phases and one phase is open; and
the phase-to-phase currents and the phase-to-phase voltage do not include the open phase.

11. The apparatus of claim 1, wherein:
the function of the local incremental voltages and replica currents and the function of the remote incremental voltages and replica currents comprise positive-sequence impedance and exclude the zero-sequence impedance for all fault types.

**12.** The apparatus of claim 11, wherein the positive-sequence impedance is calculated and refined compared to previously known values by using fault records for an external fault.

**13.** The apparatus of claim 11, wherein,

the electric power system comprises a hybrid system that includes a first section that exhibits a first positive-sequence impedance, and a second section that exhibits a second positive-sequence impedance; and
the fault location is determined by:

assuming a faulted section as the first section;
determine the fault location as corresponding with a value that minimizes a difference between a function of the local incremental voltages and replica currents and a function of the remote incremental voltages and replica currents and the first positive-sequence impedance, where the remote incremental voltages and replica currents correspond with a junction between the first section and the second section;
when the fault location is determined to be within the first section, then report the fault location;
when the fault location is not within determined to be within the first section, then assume the faulted section as the second section and determine the fault location as corresponding with a value that minimizes a difference between a function of the local incremental voltages and replica currents and a function of the remote incremental voltages and replica currents and the second positive-sequence impedance, where the local incremental voltages and replica currents correspond with a junction between the first section and the second section.

**14.** The apparatus of claim 1, wherein the electric power delivery system comprises a third terminal electrically connected to the local location and the remote location by a branch connected to a tap in the line; and

the signal processing subsystem is configured to produce a plurality of third-terminal current data and voltage data related to the third terminal; and
the fault location module is further configured to determine a fault location on the line or on the branch using the third-terminal current data and voltage data.

**15.** The apparatus of claim 1, wherein the fault location module is further configured to time align the plurality of local current data and voltage data with the plurality of remote current data and voltage data.

**Figure 1**

Figure 2

**Figure 3**

**Figure 4**

**Figure 5**

Figure 6

EP 4 760 282 A1

**Figure 7**

**Figure 8**

# EUROPEAN SEARCH REPORT

**Application Number**

EP 25 22 1310

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/068717 A1 (GONG YANFENG [US] ET AL) 22 March 2012 (2012-03-22)<br>* figures *<br>* claims *<br>* paragraphs [0021] - [0093] *<br>----- | 1-15 | INV.<br>G01R31/08 |
| A | SCHWEITZER EDMUND O. ET AL: "Speed of line protection - can we break free of phasor limitations?",<br>2015 68TH ANNUAL CONFERENCE FOR PROTECTIVE RELAY ENGINEERS IEEE,<br>30 March 2015 (2015-03-30), pages 448-461, XP032774110,<br>DOI: 10.1109/CPRE.2015.7102184<br>[retrieved on 2015-05-05]<br>* pages 450-454 *<br>----- | 1-15 | |
| A | US 2017/146613 A1 (SCHWEITZER III EDMUND O [US] ET AL) 25 May 2017 (2017-05-25)<br>* figures *<br>* claims *<br>* paragraphs [0043] - [0178] *<br>----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 7 May 2026 | Moulara, Guilhem |

EPO FORM 1503 03.82 (P04C01)

## ANNEX TO THE EUROPEAN SEARCH REPORT
## ON EUROPEAN PATENT APPLICATION NO.

EP 25 22 1310

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2026

| Patent document cited in search report | Publication date | Patent family member(s) | Publication date |
|---|---|---|---|
| US 2012068717 A1 | 22-03-2012 | CA 2752363 A1 | 16-03-2012 |
| | | US 2012068717 A1 | 22-03-2012 |
| US 2017146613 A1 | 25-05-2017 | CN 106796257 A | 31-05-2017 |
| | | EP 3194987 A1 | 26-07-2017 |
| | | US 2016077149 A1 | 17-03-2016 |
| | | US 2016077150 A1 | 17-03-2016 |
| | | US 2017012424 A1 | 12-01-2017 |
| | | US 2017146613 A1 | 25-05-2017 |
| | | US 2020350760 A1 | 05-11-2020 |
| | | WO 2016044469 A1 | 24-03-2016 |

EPO FORM P0459

For more details about this annex : see Official Journal of the European Patent Office, No. 12/82